# EUROPEAN PATENT SPECIFICATION

(11) **EP 3 503 132 B1**
(45) Date of publication and mention of the grant of the patent: **26.05.2021**
(21) Application number: 18187744.0
(22) Date of filing: 07.08.2018
(51) Int. Cl.: H01F 21/12, H01L 49/02

(54) **VARIABLE INDUCTOR AND INTEGRATED CIRCUIT USING THE VARIABLE INDUCTOR**
VARIABLE INDUKTIVITÄT UND INTEGRIERTE SCHALTUNG MIT DER VARIABLEN INDUKTIVITÄT
INDUCTEUR VARIABLE ET CIRCUIT INTÉGRÉ UTILISANT L'INDUCTEUR VARIABLE

(30) Priority: 20.12.2017 US 201715847960
(43) Date of publication of application: 26.06.2019
(73) Proprietor: National Chung Shan Institute of Science and Technology, Taoyuan City 325 (TW)
(72) Inventor: LIANG, Chia-Jen, Kaohsiung City 807 (TW); KUAN, Yen-Cheng, Kaohsiung City 802 (TW); CHIANG, Ching-Wen, Chiayi City 600 (TW); YU, Chien-Te, Taoyuan City 320 (TW)
(74) Representative: Perani & Partners S.p.A.

(56) References cited:
- CN-A- 105 244 345
- CN-B- 104 637 920
- US-A1- 2012 223 796

## Description

### FIELD OF THE INVENTION

The present disclosure relates to a variable inductor and, more particularly, to a variable inductor which can be formed on an integrated circuit.

### BACKGROUND OF THE INVENTION

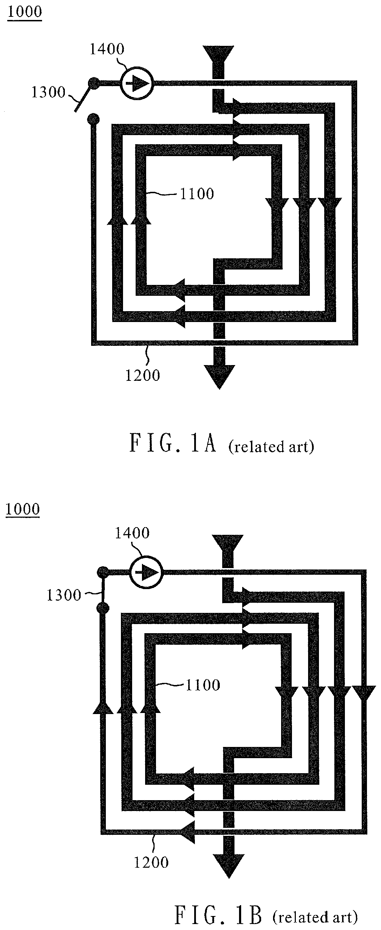

Referring to FIG. 1A and FIG. 1B, FIG. 1A and FIG. 1B shows a conventional variable inductor. The conventional variable inductor 1000 has a primary conductor 1100 and a secondary conductor 1200, a switch 1300 and a current source 1400. The secondary conductor 1200 forms a loop on the outside of the primary conductor 1100. The switch 1300 couples in series with the secondary conductor 1200 and is turned on or off to make the loop close or open. The inductance of the conventional variable inductor 1000 is varied by closing and opening the loop with the switch 1300. The current source 1400 is also coupled in series with the secondary conductor 1200 and used to control the current flow in the secondary conductor 1200 to either increase or decrease the inductance.

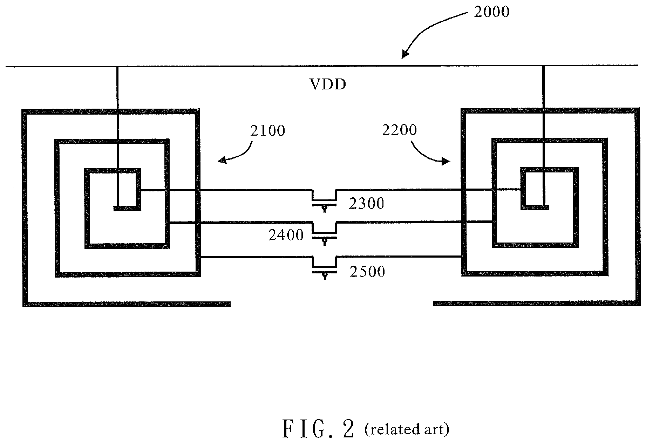

Referring to FIG. 2, FIG. 2 shows another one conventional variable inductor. The conventional variable inductor 2000 has a first conductor 2100, a second conductor 2200, a first switch 2300, a second switch 2400 and a third switch 2500. The first switch 2300, the second switch 2400 and the third switch 2500 are disposed on three current paths connected between the first conductor 2100 and the second conductor 2200, respectively. The inductance of the conventional variable inductor 2000 is varied by closing and opening the first switch 2300, the second switch 2400 and the third switch 2500.

The conventional variable inductor 1000 may have a limitedly adjustable inductance range and an insufficient inductance resolution. The conventional variable inductor 2000 may have a lower Q value, durability issues and bias concern. Other examples of variable inductors have been described in documents CN104637920 and US2012/223796 A1.

Accordingly, it is imperative to provide a variable inductor and an integrated circuit using the variable inductor which can overcome the aforesaid drawbacks of the conventional variable inductors.

### SUMMARY OF THE INVENTION

In view of the aforesaid drawbacks of the prior art, it is an obj ective of the present disclosure to provide a variable inductor and an integrated circuit using the variable inductor which can have a wider adjustable inductance range, a better inductance resolution, a higher Q value, fewer durability issues and no bias concern.

The invention is set out by the appended claims. In order to achieve the above and other obj ectives, the present disclosure provides a variable inductor which comprises a primary conductor, a first secondary conductor and a first switch. The primary conductor has a first node and a second node, wherein the first node being used to connect a first external component and the second node being used to connect a second external component. The first secondary conductor magnetically couples to the primary conductor. The first switch has two sides connected to the first secondary conductor, respectively. The first secondary conductor is formed by a single-loop structure with two changeable current paths which are operated by the states of the first switch.

Regarding the variable inductor, the variable inductor further comprises a second switch having two sides connected to the first secondary conductor, respectively, and the first secondary conductor is formed by a single-loop structure with four changeable current paths which are operated by the states of the first and second switches.

Regarding the variable inductor, the variable inductor further comprises a third switch having two sides connected to the first secondary conductor, respectively, and the first secondary conductor is formed by a single-loop structure with eight changeable current paths which are operated by the states of the first, second and third switches.

Regarding the variable inductor, the variable inductor further comprises a second secondary conductor magnetically coupling to the primary conductor and a fourth switch having two sides connected to the second secondary conductor, respectively. The second secondary conductor is formed by a single-loop structure with two changeable current paths which are operated by the states of the fourth switch.

Regarding the variable inductor, the variable inductor further comprises a fifth switch having two sides connected to the second secondary conductor, respectively, and the second secondary conductor is formed by a single-loop structure with four changeable current paths which are operated by the states of the fourth and fifth switches.

Regarding the variable inductor, the variable inductor further comprises a sixth switch having two sides connected to the second secondary conductor, respectively, and the second secondary conductor is formed by a single-loop structure with eight changeable current paths which are operated by the states of the fourth, fifth and sixth switches.

Regarding the variable inductor, the first secondary conductor is disposed on one side of the primary conductor and the second secondary conductor is disposed on another side of the primary conductor.

Regarding the variable inductor, the first node is on one end of the primary conductor and the second node is on another end of the primary conductor.

Regarding the variable inductor, the variable inductor is integrated in a radio frequency integrated circuit.

Regarding the variable inductor, the first switch is implemented by a CMOS (complementary metal oxide semiconductor) or PCB (printed circuit board) lump component.

In order to achieve the above and other objectives, the present disclosure provides an integrated circuit. The integrated circuit comprises a first component, a second component and a variable inductor. The variable inductor comprises a primary conductor, a first secondary conductor and a first switch. The primary conductor has a first node and a second node. The first node is used to connect a first external component and the second node is used to connect a second external component. The first secondary conductor magnetically couples to the primary conductor. The first switch has two sides connected to the first secondary conductor, respectively. The first secondary conductor is formed by a single-loop structure with two changeable current paths which are operated by the states of the first switch.

Regarding the integrated circuit, the variable inductor further comprises a second switch having two sides connected to the first secondary conductor, respectively, and the first secondary conductor is formed by a single-loop structure with four changeable current paths which are operated by the states of the first and second switches.

Regarding the integrated circuit, the variable inductor further comprises a third switch having two sides connected to the first secondary conductor, respectively, and the first secondary conductor is formed by a single-loop structure with eight changeable current paths which are operated by the states of the first, second and third switches.

Regarding the integrated circuit, the variable inductor further comprises a second secondary conductor magnetically coupling to the primary conductor and a fourth switch having two sides connected to the second secondary conductor, respectively. The second secondary conductor is formed by a single-loop structure with two changeable current paths which are operated by the states of the fourth switch.

Regarding the integrated circuit, the variable inductor further comprises a fifth switch having two sides connected to the second secondary conductor, respectively, and the second secondary conductor is formed by a single-loop structure with four changeable current paths which are operated by the states of the fourth and fifth switches.

Regarding the integrated circuit, the variable inductor further comprises a sixth switch having two sides connected to the second secondary conductor, respectively, and the second secondary conductor is formed by a single-loop structure with eight changeable current paths which are operated by the states of the fourth, fifth and sixth switches.

Regarding the integrated circuit, the first secondary conductor is disposed on one side of the primary conductor and the second secondary conductor is disposed on another side of the primary conductor.

Regarding the integrated circuit, the first node is on one end of the primary conductor and the second node is on another end of the primary conductor.

Regarding the integrated circuit, the integrated circuit is used for radio frequency.

Regarding the integrated circuit, the first switch is implemented by a CMOS (complementary metal oxide semiconductor).

In conclusion, give the aforesaid variable inductor and integrated circuit, the present disclosure feature a wider adjustable inductance range, a better inductance resolution, a higher Q value ,fewer durability issues and no bias concern.

### BRIEF DESCRIPTION OF THE DRAWINGS

Objectives, features, and advantages of the present disclosure are hereunder illustrated with specific embodiments in conjunction with the accompanying drawings.
FIG. 1A shows a schematic diagram of a conventional variable inductor;
FIG. 1B shows a schematic diagram of a conventional variable inductor;
FIG. 2 shows a schematic diagram of another one conventional variable inductor;
FIG. 3 is schematic diagrams of a variable inductor according to an embodiment of the present disclosure;
FIG. 4A is a plan view of different current paths of a first secondary conductor of the variable inductor according to an embodiment of the present disclosure;
FIG. 4B is a plan view of different current paths of a first secondary conductor of the variable inductor according to an embodiment of the present disclosure;
FIG. 4C is a plan view of different current paths of a first secondary conductor of the variable inductor according to an embodiment of the present disclosure;
FIG. 4D is a plan view of different current paths of a first secondary conductor of the variable inductor according to an embodiment of the present disclosure;
FIG. 4E is a plan view of different current paths of a first secondary conductor of the variable inductor according to an embodiment of the present disclosure;
FIG. 4F is a plan view of different current paths of a first secondary conductor of the variable inductor according to an embodiment of the present disclosure;
FIG. 4G is a plan view of different current paths of a first secondary conductor of the variable inductor according to an embodiment of the present disclosure;
FIG. 4H is a plan view of different current paths of a first secondary conductor of the variable inductor according to an embodiment of the present disclosure;
FIG. 5 shows an illustratively equivalent circuit of the variable inductor of FIG. 3;
FIG. 6A shows two different arrangements of a variable inductor according to another two embodiments of the present disclosure;
FIG. 6B shows two different arrangements of a variable inductor according to another two embodiments of the present disclosure;
FIG. 7 is schematic diagrams of a variable inductor according to another one embodiment of the present disclosure;
FIG. 8 shows an illustratively equivalent circuit of the variable inductor of FIG. 7;
FIG. 9A shows two different arrangements of a variable inductor according to two embodiments of the present disclosure;
FIG. 9B shows two different arrangements of a variable inductor according to two embodiments of the present disclosure; and
FIG. 10 shows a simulation result of FIG. 3.

### DETAILED DESCRIPTION OF THE PREFERRED EMBODIMENTS

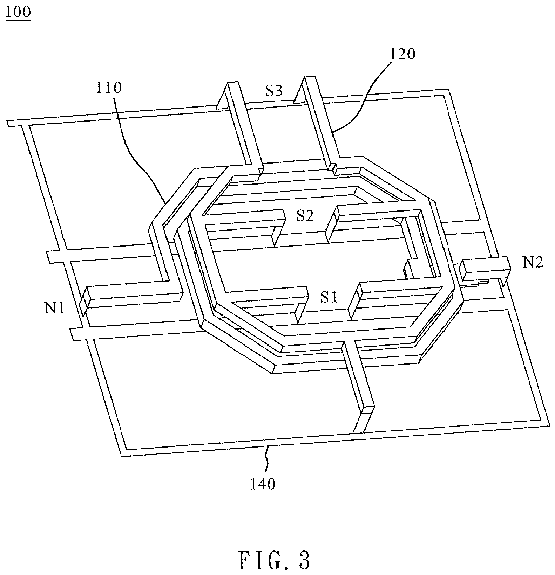

Referring to FIG. 3, FIG. 3 is schematic diagrams of a variable inductor according to an embodiment of the present disclosure. The variable inductor 100 has a primary conductor 110, a first secondary conductor 120, a first switch S1, a second switch S2 and a third switch S3, wherein the primary conductor 110 and the first secondary conductor 120 magnetically couple to each other to form a transformer structure. By controlling the first through third switches S1 through S3, the equivalent inductance of the first secondary conductor 120 and coupling factor are changed due to magnetic coupling theory of the transformer structure. The inductance value of the primary conductor 110 is changed as the equivalent inductance of the first secondary conductor 120 and coupling factor are changed. Therefore, the primary conductor 110, the first secondary conductor 120 and the first through third switches S1 through S3 can achieve the object of variable inductance.

In FIG. 3, the first secondary conductor 120 is disposed on the top of the primary conductor 110. The first switch S1, the second switch S2 and the third switch S3 can be implemented on a substrate or printed circuit board 140. The substrate or printed circuit board 140 can be disposed under the bottom of the primary conductor 110.

The first switch S1 has two sides connected to the first secondary conductor 120, respectively. The second switch S2 has two sides connected to the first secondary conductor 120, respectively. The third switch S3 has two sides connected to the first secondary conductor 120, respectively. The first switch S1, the second switch S2 and the third switch S3 are formed on current paths P1- P3, respectively.

The first secondary conductor 120 is formed by a single-loop structure. The current paths P1- P3 are formed as three different bypaths of the single-loop structure. Therefore, if the state of anyone of the first switch S1, the second switch S2 and the third switch S3 are changed, then the current paths of the first secondary conductor 120 is changed.

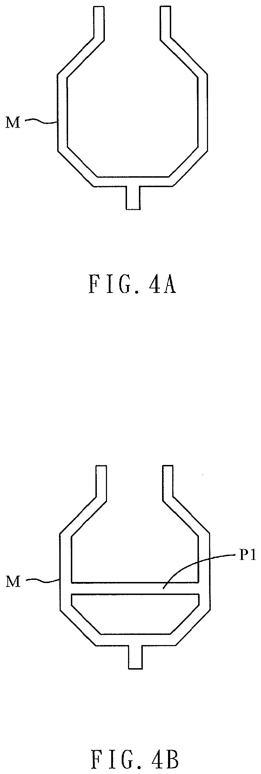

FIGS. 4A through 4H show eight different current paths of the first secondary conductor 120. In FIG. 4A, all of the first switch S1, the second switch S2 and the third switch S3 operated to be open. The first secondary conductor 120 is formed by a single-loop structure with a main branch M.

In FIG. 4B, only the first switch S1 is operated to be closed. The first secondary conductor 120 is formed by a single-loop structure with the main branch M and the current path P1.

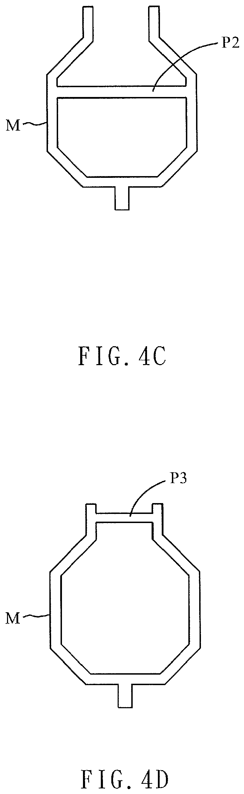

In FIG. 4C, only the second switch S2 is operated to be closed. The first secondary conductor 120 is formed by a single-loop structure with the main branch M and the current path P2.

In FIG. 4D, only the third switch S3 is operated to be closed. The first secondary conductor 120 is formed by a single-loop structure with the main branch M and the current path P3.

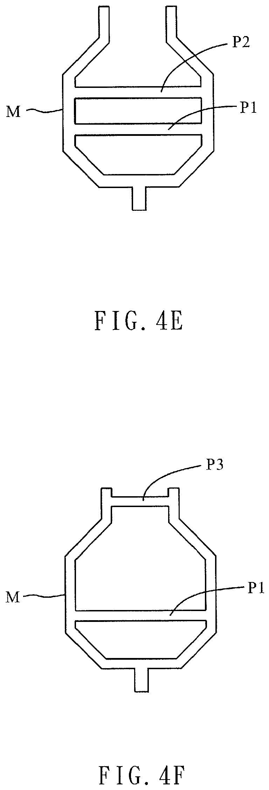

In FIG. 4E, the first switch S1 and the second switch S2 are operated to be closed. The first secondary conductor 120 is formed by a single-loop structure with the main branch M, the current path P1 and the current path P2.

In FIG. 4F, the first switch S1 and the third switch S3 are operated to be closed. The first secondary conductor 120 is formed by a single-loop structure with the main branch M, the current path P1 and the current path P3.

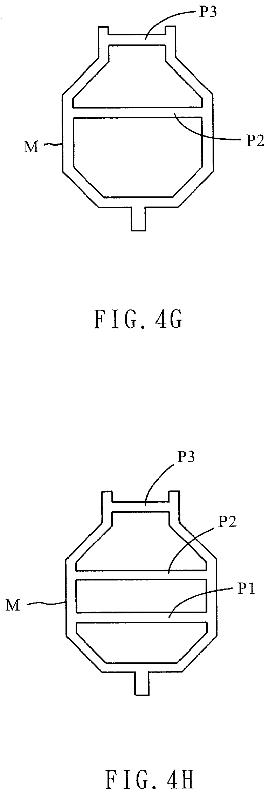

In FIG. 4G, the second switch S2 and the third switch S3 are operated to be closed. The first secondary conductor 120 is formed by a single-loop structure with the main branch M, the current path P2 and the current path P3.

In FIG. 4H, all of the first switch S1, the second switch S2 and the third switch S3 operated to be closed. The first secondary conductor 120 is formed by a single-loop structure with the main branch M, the current path P1, the current path P2 and the current path P3.

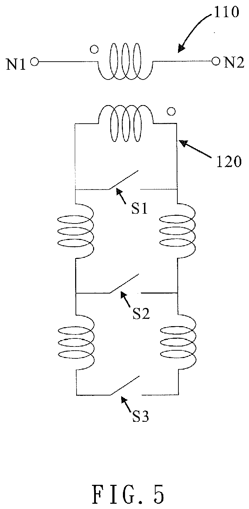

The first secondary conductor 120 is formed by a single-loop structure with eight changeable current paths which are determined by the state of the first switch S1, the second switch S2 and third switch S3. The inductance of the variable inductor 100 is varied by closing and opening the first switch S1, the second switch S2 and the third switch S3. Therefore, in this embodiment, the variable inductor 100 has an adjustable inductance range which includes eight different inductance values corresponding to eight different current paths (as shown as FIG. 4A through 4H), respectively. FIG. 5 is an illustratively equivalent circuit of the variable inductor of FIG. 3. The inductance from the first node N1 through the second node N2 of the primary conductor 110 is changed according to the state of the switch S1 through S3 of the first secondary conductor 120.

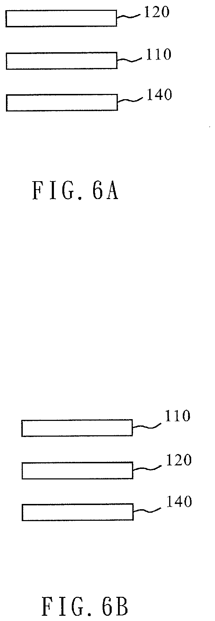

FIGS. 6A and 6B show two different arrangements of a variable inductor according to two embodiments of the present disclosure. In FIG. 6A, the first secondary conductor 120 is disposed on the top of the primary conductor 110, and the substrate or printed circuit board 140 is disposed under the bottom of the primary conductor 110. In FIG. 6B, the first secondary conductor 120 is disposed under the bottom of the primary conductor 110, and the substrate or printed circuit board 140 is disposed under the bottom of first secondary conductor 120.

In other one embodiment, the third switch S3 can be eliminated. In that embodiment, the first secondary conductor 120 is formed by a single-loop structure with four changeable current paths which are operated by the states of the first switch S1 and the second switch S2.

In the other one embodiment, both the second switch S2 and the third switch S3 can be eliminated. In that embodiment, the first secondary conductor 120 is formed by a single-loop structure with two changeable current paths which are determined by the state of the first switch S1.

In still the other one embodiment, the number of the switches can be N₁ and the first secondary conductor 120 is formed by a single-loop structure with M₁ changeable current paths which are determined by the state of the N₁ switches, wherein N₁ is more than 3 and M₁ is more than 8.

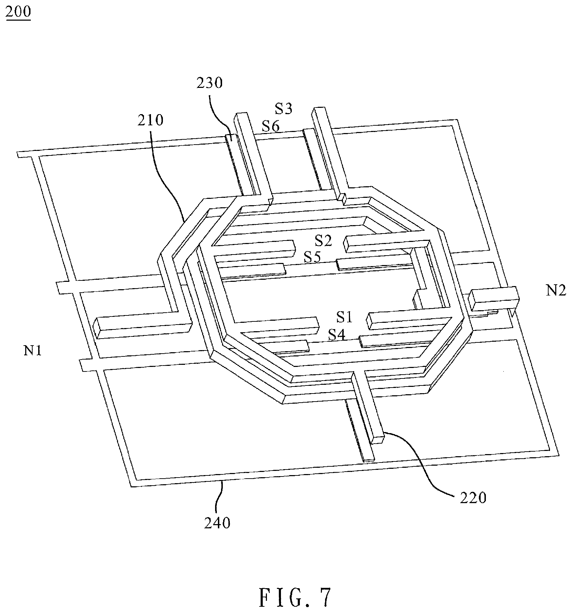

Referring to FIG. 7, FIG. 7 is schematic diagrams of a variable inductor according to another one embodiment of the present disclosure. The variable inductor 200 has a primary conductor 210, a first secondary conductor 220, a second secondary conductor 230, a first switch S1, a second switch S2, a third switch S3, a fourth switch S4, a fifth switch S5 and a sixth switch S6.

In FIG. 7, the second secondary conductor 230 is disposed under the bottom of the primary conductor 210. The fourth switch S4, the fifth switch S5 and the sixth switch S6 can be implemented on a substrate or printed circuit board 240. The printed circuit board 240 can be disposed under the bottom of the primary conductor 210.

The fourth switch S4 has two sides connected to the second secondary conductor 230, respectively. The fifth switch S5 has two sides connected to the second secondary conductor 230, respectively. The sixth switch S6 has two sides connected to the second secondary conductor 230, respectively. The fourth switch S4, the fifth switch S5 and the sixth switch S6 are formed on another three current paths, respectively.

The second secondary conductor 230 is formed by a single-loop structure. The three current paths are formed as three different bypaths of the single-loop structure. Therefore, if the state of anyone of the fourth switch S4, the fifth switch S5 and the sixth switch S6 are changed, then the current paths of the second secondary conductor is changed.

The structure of the first secondary conductor 220 and the second secondary conductor 230 are roughly the same as the structure of the first secondary conductor 120. Therefore, the detailed description of the first secondary conductor 220 and the second secondary conductor 230 is omitted.

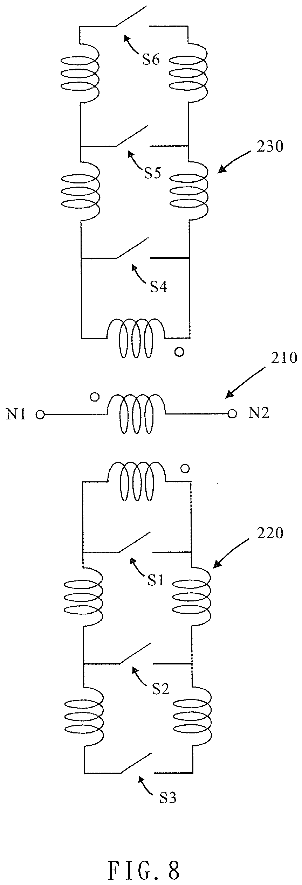

The first secondary conductor 220 is formed by a single-loop structure with eight changeable current paths which are determined by the state of the first switch S1, the second switch S2 and third switch S3. The second secondary conductor 230 is also formed by a single-loop structure with eight changeable current paths which are determined by the state of the fourth switch S4, the fifth switch S5 and the sixth switch S6. The inductance of the variable inductor 200 is varied by closing and opening the first switch S1, the second switch S2, the third switch S3, the fourth switch S4, the fifth switch S5 and the sixth switch S6. Therefore, in this embodiment, the variable inductor 200 has an adjustable inductance range which includes 64 different inductance values corresponding to 8*8 different current paths, respectively. FIG. 8 is an illustratively equivalent circuit of the variable inductor of FIG. 7.

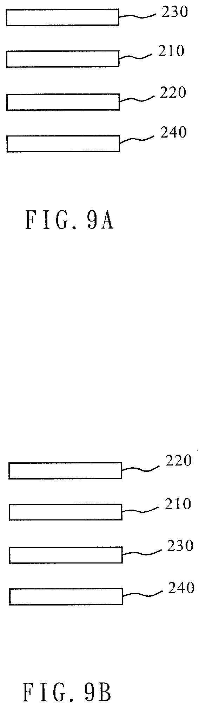

FIGS. 9A and 9B show two different arrangements of a variable inductor according to two embodiments of the present disclosure. In FIG. 9A, the second secondary conductor 230 is disposed on the top of the primary conductor 210, the first secondary conductor 220 is disposed under the bottom of the primary conductor 210, and the printed circuit board 240 is disposed under the bottom of the first secondary conductor 220. In FIG. 9B, the first secondary conductor 220 is disposed on the top of the primary conductor 210, the second secondary conductor 230 is disposed under the bottom of the primary conductor 210, and the printed circuit board 240 is disposed under the bottom of the second secondary conductor 230.

In other one embodiment, the sixth switch S6 can be eliminated. In that embodiment, the second secondary conductor 230 is formed by a single-loop structure with four changeable current paths which are operated by the states of the fourth switch S4 and the fifth switch S5.

In the other one embodiment, both the fifth switch S5 and the sixth switch S6 can be eliminated. In that embodiment, the second secondary conductor 230 is formed by a single-loop structure with two changeable current paths which are determined by the state of the fourth switch S4.

In still the other one embodiment, the number of the switches can be N₂ and the second secondary conductor 230 is formed by a single-loop structure with M₂ changeable current paths which are determined by the state of the N₂ switches, wherein N₂ is more than 3 and M₂ is more than 8.

The variable inductor is suitable for being integrated in an integrated circuit, for example, a radio frequency integrated circuit. A first node N1 of the variable inductor can be disposed on one end of the primary conductor of the variable inductor and a second node N2 of the variable inductor can be disposed on another end of the primary conductor of the variable inductor. The first node N1 can connect to a first external component, for example, a first component of the integrated circuit. The second node N2 can connect to a second external component, for example, a second component of the integrated circuit.

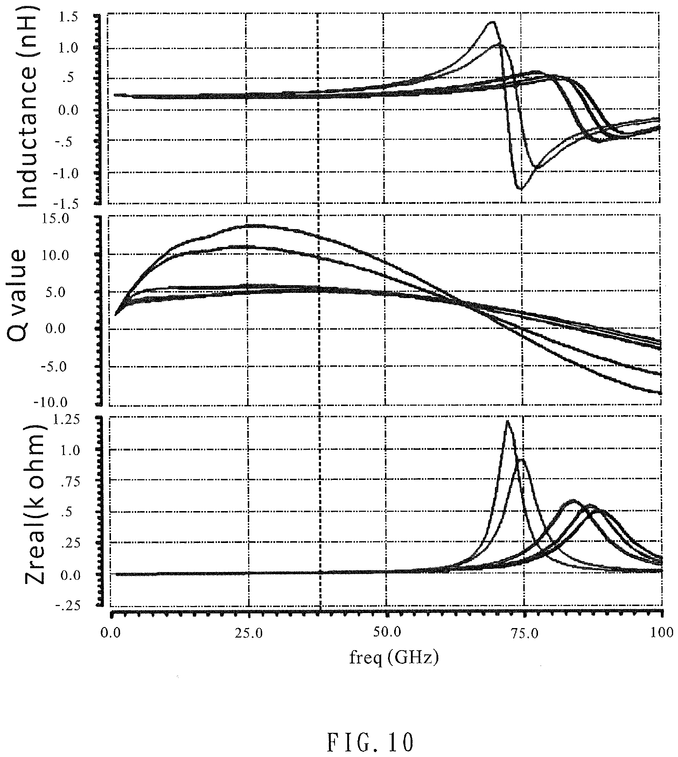

Referring to FIG. 10, FIG. 10 shows a simulation result of FIG.3. In FIG. 10, three switches are implemented by 28nm CMOS (complementary metal oxide semiconductor). The adjustable inductance range is 187pH- 277pH.

In conclusion, the aforesaid variable inductor and integrated circuit, the present disclosure feature a wider adjustable inductance range, a better inductance resolution, a higher Q value ,fewer durability issues or no bias concern.

## Claims

1. A variable inductor (100, 200) being used to connect a first external component and a second external component, the variable inductor (100, 200) comprising:
a primary conductor (110, 210) having a first node (N1) and a second node (N2), the first node (N1) being used to connect the first external component, the second node (N2) being used to connect the second external component;
a first secondary conductor (120, 220), magnetically coupling to the primary conductor (110, 210) to form a transformer structure with the primary conductor and first secondary conductor forming primary (210) and secondary (220) coils of the transformer structure and the first secondary conductor being disposed above or below the primary conductor;
a first switch (S1) having two sides connected to the first secondary conductor (110, 220), respectively;
wherein the first secondary conductor (110, 210) is formed by a single-loop structure with two changeable current paths (M, "M and P1") which are operated by the states of the first switch (SI);
a second switch (S2) having two sides connected to the first secondary conductor (120, 220), respectively, and the first secondary conductor (120, 220) is formed by a single-loop structure with four changeable current paths (M, "M and P1", "M and P2", "M, P1 and P2") which are operated by the states of the first and second switches (S1, S2); and
a third switch (S3) having two sides connected to the first secondary conductor (120, 220), respectively, and the first secondary conductor (120, 220) is formed by a single-loop structure with eight changeable current paths (M, "M and P1", "M and P2", "M and P3", "M, P1 and P2", "M, P1 and P3", "M, P2 and P3", "M, P1, P2 and P3") which are operated by the states of the first, second and third switches (S1, S2, S3), whereby the inductance value of the primary conductor is changed as the equivalent inductance of the first secondary conductor and coupling factor are changed.

2. The variable inductor (100, 200) of claim 1, wherein the first node (N1) is disposed on one end of the primary conductor (110, 210) and the second node (N2) is disposed on another end of the primary conductor (110, 210).

3. The variable inductor (100, 200) of claim 1, wherein the variable inductor (100, 200) is integrated in a radio frequency integrated circuit.

4. The variable inductor (100, 200) of claim 3, wherein the first switch (S1) is implemented by a CMOS (complementary metal oxide semiconductor).

5. The variable inductor (100, 200) of claim 3, wherein the first switch (S1) is implemented by a PCB (printed circuit board) lump component.

6. An integrated circuit comprising:
a first component;
a second component; and
a variable inductor (100, 200) according to any one of claims 1 to 4, the variable inductor (100, 200) being connected to the first component and the second component.

## Patentansprüche

1. Ein variabler Induktor (100, 200), der dazu verwendet wird, um eine erste externe Komponente und eine zweite externe Komponente zu verbinden, wobei der variable Induktor (100, 200) Folgendes umfasst:
einen Primärleiter (110, 210) aufweisend einen ersten Knoten (N1) und einen zweiten Knoten (N2), wobei der erste Knoten (M1) zum Verbinden der ersten externen Komponente verwendet wird, der zweite Knoten (N2) zum Verbinden der zweiten externen Komponente verwendet wird;
einen ersten Sekundärleiter (120, 220), der magnetisch mit dem Primärleiter (110, 210) gekoppelt ist, um eine Transformatorstruktur mit dem Primärleiter zu bilden und wobei der erste Sekundärleiter eine Primär- (210) und Sekundärspule (220) der Transformatorstruktur bildet und der erste Sekundärleiter oberhalb oder unterhalb des Primärleiters angeordnet ist;
einen ersten Schalter (S1) aufweisend zwei Seiten, die jeweils mit dem ersten Sekundärleiter (110, 220) verbunden sind;
wobei der erste Sekundärleiter (110, 210) durch eine Einzelschleifenstruktur mit zwei veränderbaren Strompfaden (M, "M und P1") gebildet ist, die durch die Zustände des ersten Schalters (S1) betrieben werden;
einen zweiten Schalter (S2) aufweisend zwei Seiten, die jeweils mit dem ersten Sekundärleiter (120, 220) verbunden sind, und wobei der erste Sekundärleiter (120, 220) durch eine Einzelschleifenstruktur mit vier veränderbaren Strompfaden (M, "M und P1", "M und P2", "M, P1 und P2") gebildet ist, die durch die Zustände des ersten und zweiten Schalters (S1, S2) betrieben werden; und
einen dritten Schalter (S3) aufweisend zwei Seiten, die jeweils mit dem ersten Sekundärleiter (120, 220) verbunden sind, und wobei der erste Sekundärleiter (120, 220) durch eine Einzelschleifenstruktur mit acht veränderbaren Strompfaden (M, "M und P1" "M und P2" "M und P3" "M, P1 und P2" "M, P1 und P3" "M, P2 und P3", "M, P1, P2 und P3") gebildet ist, die durch die Zustände des ersten, zweiten und dritten Schalters (S1, S2, S3) betrieben werden, wobei der Induktivitätswert des Primärleiters sich ändert, wenn die äquivalente Induktivität des ersten Sekundärleiters und der Koppelfaktor geändert werden.

2. Variabler Induktor (100, 200) nach Anspruch 1, wobei der erste Knoten (N1) an einem Ende des Primärleiters (110, 210) und der zweite Knoten (N2) an einem anderen Ende des Primärleiters (110, 210) angeordnet ist.

3. Variabler Induktor (100, 200) nach Anspruch 1, wobei der variable Induktor (100, 200) in einer integrierten Funkfrequenzschaltung integriert ist.

4. Variabler Induktor (100, 200) nach Anspruch 3, wobei der erste Schalter (S1) durch einen CMOS (komplementärer Metalloxidhalbleiter) implementiert wird.

5. Variabler Induktor (100, 200) nach Anspruch 3, wobei der erste Schalter (S1) durch eine konzentrierte PCB-Komponente (gedruckte Leiterplatte) implementiert wird.

6. Eine integrierte Schaltung, umfassend:
eine erste Komponente;
eine zweite Komponente; und
einen variablen Induktor (100, 200) nach irgendeinem der Ansprüche von 1 bis 4, wobei der variable Induktor (100, 200) mit der ersten Komponente und mit der zweiten Komponente verbunden ist.

## Revendications

1. Inducteur variable (100, 200) étant utilisé pour connecter un premier composant externe et un deuxième composant externe, l'inducteur variable (100, 200) comprenant :
un conducteur primaire (110, 210) ayant un premier nœud (N1) et un deuxième nœud (N2), le premier nœud (N1) étant utilisé pour connecter le premier composant externe, le deuxième nœud (N2) étant utilisé pour connecter le deuxième composant externe ;
un premier conducteur secondaire (120, 220), se couplant magnétiquement au conducteur primaire (110, 210) pour former une structure de transformateur avec le conducteur primaire et le premier conducteur secondaire formant des bobines primaire (210) et secondaire (220) de la structure de transformateur et le premier conducteur secondaire étant disposé au-dessus ou au-dessous du conducteur primaire ;
un premier interrupteur (S1) ayant deux côtés connectés au premier conducteur secondaire (110, 220), respectivement ;
dans lequel le premier conducteur secondaire (110, 210) est formé par une structure à boucle unique avec deux chemins de courant (M, « M et P1 ») modifiables qui sont opérés par les états du premier interrupteur (S1) ;
un deuxième interrupteur (S2) ayant deux côtés connectés au premier conducteur secondaire (120, 220), respectivement, et le premier conducteur secondaire (120, 220) est formé par une structure à boucle unique avec quatre chemins de courant (M, « M et P1 », « M et P2 », « M, P1 et P2 ») qui sont opérés par les états des interrupteurs premier et deuxième (S1, S2) ; et
un troisième interrupteur (S3) ayant deux côtés connectés au premier conducteur secondaire (120, 220), respectivement, et le premier conducteur secondaire (120, 220) est formé par une structure à boucle unique avec huit chemins de courant (M, « M et P1 » « M et P2 » « M et P3 » « M, P1 et P2 » « M, P1 et P3 » « M, P2 et P3 », « M, P1, P2 et P3 ») qui sont opérés par les états des interrupteurs premier, deuxième et troisième (S1, S2, S3), par lequel la valeur d'inductance du conducteur primaire est modifiée lorsque l'inductance équivalente du premier conducteur secondaire et un facteur de couplage sont modifiés.

2. Inducteur variable (100, 200) de la revendication 1, dans lequel le premier nœud (N1) est disposé sur une extrémité du conducteur primaire (110, 210) et le deuxième nœud (N2) est disposé sur une autre extrémité du conducteur primaire (110, 210).

3. Inducteur variable (100, 200) de la revendication 1, dans lequel l'inducteur variable (100, 200) est intégré dans un circuit intégré à radiofréquence.

4. Inducteur variable (100, 200) de la revendication 3, dans lequel le premier interrupteur (S1) est implémenté par un CMOS (semi-conducteur à oxyde de métal complémentaire).

5. Inducteur variable (100, 200) de la revendication 3, dans lequel le premier interrupteur (S1) est implémenté par un composant de masse de PCB (carte de circuit imprimé).

6. Circuit intégré comprenant :
un premier composant ;
un deuxième composant ; et
un inducteur variable (100, 200) selon l'une quelconque des revendications 1 à 4, l'inducteur variable (100, 200) étant connecté au premier composant et au deuxième composant.
